# EUROPEAN PATENT SPECIFICATION

(11) **EP 2 434 552 B1**
(45) Date of publication and mention of the grant of the patent: **05.11.2014**
(21) Application number: 11182236.7
(22) Date of filing: 21.09.2011
(51) Int. Cl.: H01L 31/05, H01L 31/02, H01L 31/042

(54) **Mixed wiring schemes for shading robustness**
Gemischte Verdrahtungsschemen für die Verschattungsrobustheit
Schémas de câblage mélangés pour robustesse d'ombrage

(30) Priority: 24.09.2010 US 890368
(43) Date of publication of application: 28.03.2012
(73) Proprietor: Alta Devices, Inc., Santa Clara, CA 95054 (US)
(72) Inventor: Hegedus, Andreas G., Burlingame, CA California 94010 (US); Kizilyalli, Isik C., San Francisco, CA California 94117 (US)
(74) Representative: Harris, Jennifer Lucy

(56) References cited:
- EP-A2- 1 429 394
- WO-A1-2009/036502
- QI ZHANG ET AL: "A novel topology for solving the partial shading problem in photovoltaic power generation system", IEEE 6TH INTERNATIONAL POWER ELECTRONICS AND MOTION CONTROL CONFERENCE, 2009 : IPEMC '09 ; WUHAN, CHINA, 17 - 20 MAY 2009, IEEE, PISCATAWAY, NJ, USA, 17 May 2009 (2009-05-17), pages 2130-2135, XP031535474, ISBN: 978-1-4244-3556-2

## Description

### BACKGROUND OF THE INVENTION

### Field of the Invention

The present invention relates generally to solar cells, solar panels and or solar arrays and more particularly to electrical interconnections for devices adapted to capture solar energy, such as solar cells, solar panels and/or solar arrays.

### Description of the Related Art

Solar devices, such as solar cells, solar panels or solar arrays are typically positioned for service to have an unobstructed, line-of sight view of the sun. The unobstructed access to the sun maximizes the quanta of light impinging the device, which maximizes the resulting energy produced and/or captured. Traditionally, places such as rooftops, relatively flat surfaces on or near the ground, and hillsides with low vegetation are suitable locations.

However, even in these suitable locations, the solar devices may experience random instances where the sunlight is blocked. For example, objects such as clouds, plants and other structures or phenomena may temporarily or permanently shade a device or devices. The shading effect produced by these objects reduces the efficiency of the device or devices and power output may be minimized or eliminated entirely.

A natural variation of solar cell performance exists within the manufacturing process. In order to prevent the lower performing cells from setting the output for the entire module, a particular wiring scheme may be selected during the manufacturing of the module. While such scheme may indeed be robust, the same scheme may limit the total power produced by the rest of the cells within the module or panel. Therefore, the module will not be optimized for full generation of power.

WO 2009/036502 A1 discloses a circuit for a solar cell array formed from clusters of serially connected solar cells that switch the output from a cluster depending on the experienced level of illumination by the cluster. Clusters in or near fall illumination are switched to a high current power line and shaded clusters are switched to a low current power line.

Therefore, there is a need for an electrical coupling scheme for the solar devices that reduces the shading effect and maximizes the efficiency of the solar devices. The present invention addresses such a need.

### SUMMARY OF THE INVENTION

Embodiments herein provide methods and apparatuses for electrical interconnections utilized in devices adapted to capture solar energy, such as solar cells, solar panels and/or solar arrays. In one embodiment, a solar panel is described and includes a first plurality of solar devices positioned in a center of the solar panel in electrical communication with a first circuit, and a second plurality of solar devices surrounding the first plurality of solar devices, the second plurality of solar devices in electrical communication with a second circuit, the second circuit being different than the first circuit.

In another embodiment, the solar panel includes a first plurality of solar devices positioned in a center of the solar panel electrically coupled with a serial wiring circuit, and a second plurality of solar devices surrounding the first plurality of solar devices, the second plurality of solar devices electrically coupled with a parallel wiring circuit.

In another embodiment, the solar panel includes a first plurality of solar devices positioned in a center of the solar panel electrically coupled with a serial wiring circuit, and a second plurality of solar devices surrounding the first plurality of solar devices, the second plurality of solar devices electrically coupled with an H-bridge wiring circuit.

In another embodiment, the solar panel includes a first plurality of solar devices positioned in a center of the solar panel electrically coupled with a parallel wiring circuit, and a second plurality of solar devices surrounding the first plurality of solar devices, the second plurality of solar devices electrically coupled with an H-bridge wiring circuit.

In another embodiment, the solar panel includes a first plurality of solar devices positioned in a center of the solar panel electrically coupled with a parallel wiring circuit, and a second plurality of solar devices surrounding the first plurality of solar devices, the second plurality of solar devices electrically coupled with a serial wiring circuit.

In another embodiment, the solar panel includes a first plurality of solar devices positioned in a center of the solar panel electrically coupled with a parallel wiring circuit, and a second plurality of solar devices surrounding the first plurality of solar devices, the second plurality of solar devices electrically coupled with a serial wiring circuit.

In another embodiment, the solar panel includes a first plurality of solar devices positioned in a center of the solar panel electrically coupled with an H-bridge wiring circuit, and a second plurality of solar devices surrounding the first plurality of solar devices, the second plurality of solar devices electrically coupled with a serial wiring circuit.

In another embodiment, the solar panel includes a first plurality of solar devices positioned in a center of the solar panel electrically coupled with an H-bridge wiring circuit, and a second plurality of solar devices surrounding the first plurality of solar devices, the second plurality of solar devices electrically coupled with a parallel wiring circuit.

In another embodiment, a method for electrically connecting a solar pane is described and includes exposing light to a solar panel having a center area comprising a first plurality of solar devices that are at least partially bordered by a second plurality of solar devices positioned outside of the center area, electrically connecting the first plurality solar devices with a first electrical circuit, and electrically connecting the second plurality of solar devices with a second electrical circuit that is different than the first electrical circuit.

In another embodiment, a method for transferring electrical power from a solar panel to a load is described and includes exposing light to a solar panel having a center area comprising a first plurality of solar devices that are at least partially bordered by a second plurality of solar devices positioned outside of the center area, and transferring electrical power to the load from the first plurality of solar devices through an electrical circuit, the electrical power from the first plurality of solar devices being independent of the electrical power production potential of the second plurality of solar devices.

In some embodiments, by eliminating the shaded cells from the circuit of the panel, the rest of the panel will not be limited to the output of the eliminated, lower performing cells. The partitioned panel contains a more aggressive wiring scheme in the center and a more robust wiring scheme at the edges. This embodiment differs from the single homogenous approach which provides for the entire panel including the center unshaded cells will not produce at an optimum.

### BRIEF DESCRIPTION OF THE DRAWINGS

So that the manner in which the above-recited features of the invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figure 1 is a schematic top view of a solar panel.

Figure 2 is a top view of other forms of solar panels.

Figure 3 is a top view of a one embodiment of a solar panel having a heterogeneous wiring scheme.

Figure 4 is a top view of another embodiment of a solar panel having a heterogeneous wiring scheme.

To facilitate understanding, identical reference numerals have been used, where possible, to designate identical elements that are common to the figures. It is contemplated that elements disclosed in one embodiment may be beneficially utilized on other embodiments without specific recitation.

### DETAILED DESCRIPTION

The present invention relates generally to solar cells, solar panels and or solar arrays and more particularly to electrical interconnections for devices adapted to capture solar energy, such as solar cells, solar panels and/or solar arrays. The following description is presented to enable one of ordinary skill in the art to make and use the invention and is provided in the context of a patent application and its requirements. Various modifications to the preferred embodiments and the generic principles and features described herein will be readily apparent to those skilled in the art. Thus, the present invention is not intended to be limited to the embodiments shown, but is to be accorded the widest scope consistent with the principles and features described herein.

Embodiments of the invention generally provide methods and apparatus for electrical interconnections utilized in devices adapted to capture solar energy, such as solar cells, solar panels and/or solar arrays. The electrical interconnections as described herein are configured to minimize or eliminate shading effects produced by an object or objects that may temporarily or permanently block sunlight from a solar device.

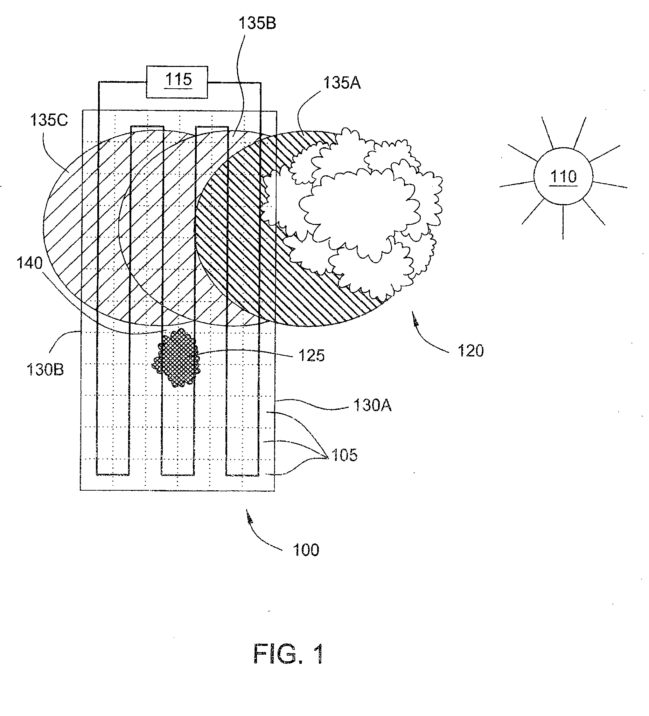

Figure 1 is a schematic top view of one embodiment of a solar panel 100. The solar panel 100 includes a plurality of cells 105 that receive light from a light source, such as the sun 110. Each of the cells 105 may be a photovoltaic device including p-n junctions adapted to convert sunlight into electricity. The solar panel 100 includes, for example, seventy two cells 105 that are interconnected in a homogenous serial wiring scheme to a load 115, which may be an electrical appliance, a storage medium, such as a battery or a capacitor, or a connection to a power grid.

The solar panel 100 depicted in Figure 1 is at least partially shaded by one or more shading sources 120, 125. One or both of the shading sources 120, 125 negatively affect the performance of the solar panel 100 and reduce the power available to the load 115. In Figure 1, the shading source 125 is a spot or area of solid matter which may be organic or inorganic matter that is attached to or supported by a surface of the solar panel 100. Examples of organic or inorganic matter that may be representative of the shading source 125 include soil, bird or animal droppings, vegetation matter, such as leaves, limbs, pollen, bark, nuts, berries, etc., as well as other matter. The shading source 125 may be deposited on a surface of the solar panel 100 at random intervals and/or random areas of the solar panel 100 and operates to shade at least a portion of the solar panel 100. The shading source 120 is a plant, such as a tree or bush, which has been planted or allowed to grow in proximity to the solar panel 100. The shading sources 120, 125 may block light completely or in part from the cell or cells 105 that are under or otherwise shaded by the sources 120, 125. The shading of one or more cells 105 minimizes the efficiency of the entire solar panel 100 by reducing the net power available from the solar panel 100 to the load 115.

The shading source 120 may block particular cells 105 for portions of a day as a shadow 135A-135C moves across the surface of the solar panel 100. In contrast, the shading source 125 may block particular cells completely or in part during all daylight hours.

The shading source 120 may be considered a permanent obstruction that affects the solar panel 100 day after day until the source 120 is removed or the solar panel 100 is relocated. In contrast, the shading source 125 may be considered a temporary obstruction that may be mitigated by weather events (*e.g.*, wind or rain), decomposition of the shading source, or physical cleaning of the solar panel 100. Additionally, the frequency and/or probability of the occurrence of the shading sources 120, 125 is different. For example, the occurrence of the shading source 120 may be predicted by observational methods while the occurrence of the shading source 125 is temporally random and may affect any area of the solar panel 100 with assumed equal probability.

The solar panel 100 may experience shading events other than the shadowing produced by the shading sources 120, 125 with similar reduction in efficiency. For example, other temporary obstructions include cloud formations, shadows from parked vehicles, shadows from construction activities, among other temporary obstructions that cause random shading events. Permanent obstructions include fixed obstructions, such as a tree or shrub similar to the shading source 120 as well as buildings, billboards, signs, or other structures that may shade at least a portion of the solar panel 100.

With the exception of a surface attached or surface supported shading source, such as the shading source 125, other temporary obstructions shade the solar panel 100 in a manner similar to a permanent obstruction due to the axial rotation of the earth and/or movement of the obstruction itself. For example, a permanent obstruction such as the shading source 120 will initially form a shadow over an edge 130A of the solar panel 100 and the shadow subsequently moves toward a center 140 and across the solar panel 100 to an edge 130B (in an afternoon example). Alternatively, a permanent obstruction such as the shading source 120 may initially form a shadow over the edge 130B of the solar panel 100 and the shadow subsequently moves toward a center 140 and across the solar panel 100 to the edge 130A (in a morning example). Likewise, a temporary obstruction, such as a cloud, may initially form a shadow over one edge and move across the solar panel 100. In the case of a shadow formed by a cloud, the shadow may subsequently form a shadow over the entire solar panel 100 due to movement of the cloud and/or the rotation of the earth. In either case, the edge 130A or 130B that was initially shaded may remain shaded for an extended time period relative to other portions of the solar panel 100.

In one example during afternoon hours, the shading source 120 forms a first shadow 135A at or near a first edge 130A of the solar panel 100. As the earth rotates about its axis, the first shadow 135A grows into a second shadow 135B that eventually shades a center 140 of the solar panel 100 as well as the first edge 130A. As the earth continues its rotation, the second shadow 135B extends to a third shadow 135C that shades a second edge 130B as well as the center 140 and the first edge 130A of the solar panel 100. While not shown, a temporary obstruction such as a cloud may cause shading of the solar panel 100 that is similar to the shading caused by the shading source 120. For example, a shadow cast by a cloud may shade the first edge 130A forming the first shadow 135A and move across the solar panel 100 which extends the first shadow 135A into the second and third shadows 135B, 135C. In either example, the first edge 130A may remain shaded by the shading source 120 or cloud for an extended period of time relative to the center 140 and the second edge 130B.

As the cells 105 on the first edge 130A experience longer periods of shade and/or a greater aversion of sunlight relative to the center 140, the cells 105 on the first edge 130A are operating at a reduced efficiency as compared to other cells 105 receiving more sunlight. The homogenous wiring scheme connecting the cells 105 to the load 115 aggregates the current and/or voltage from each of the cells 105 on the solar panel 100 and delivers a net current and/or voltage to the load 115. Thus, if one or more of the cells 105 are shaded and not operating at or near full efficiency, the net current and/or voltage available to the load 115 is reduced. The reduced net power produced by the solar panel 100 may occur even though the center 140 and/or the second edge 130B may be receiving a maximum or near maximum quanta of light.

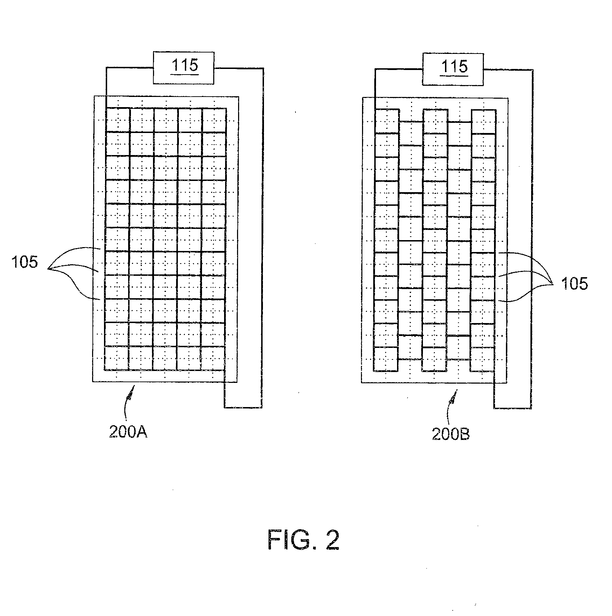

Figure 2 depicts a top view of other forms of solar panels 200A, 200B that may experience a shading effect as described in Figure 1. Each of the cells 105 of the solar panel 200A are interconnected in a homogenous, serial-parallel wiring scheme while each of the cells 105 of the solar panel 200B are interconnected in a homogenous, "H-bridge" wiring scheme. In either of these solar panels 200A, 200B, a shading effect as described herein negatively affects the performance of the solar panels 200A, 200B due to the homogenous wiring scheme.

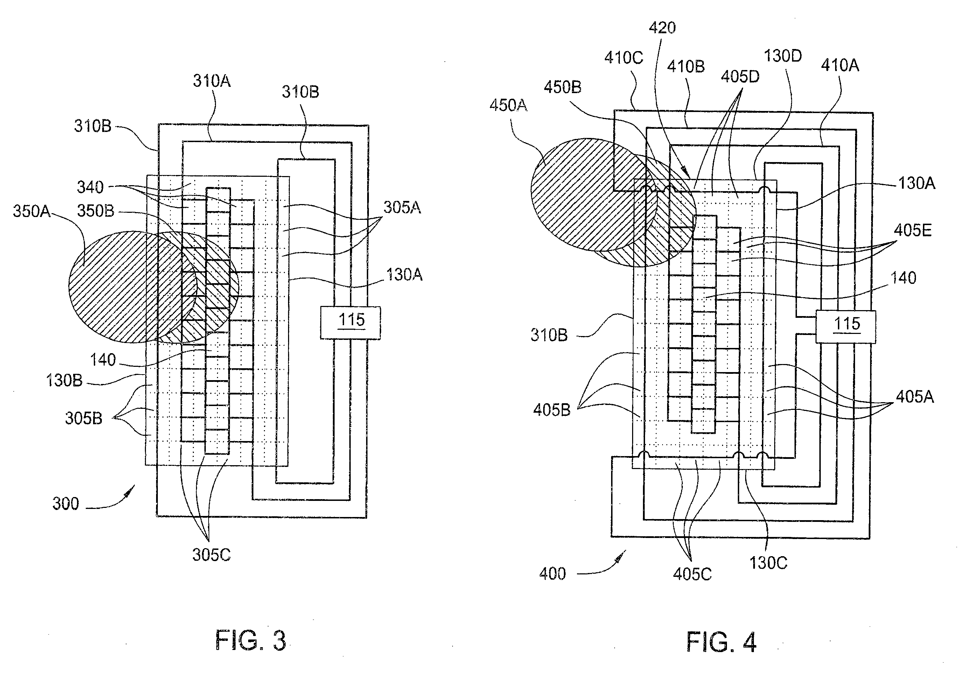

Figure 3 depicts a top view of a solar panel 300 having a heterogeneous wiring scheme, which includes a first circuit 310A interconnecting cells 340 in a center 140 of the solar panel 300 and a plurality of second circuits 310B interconnecting cells 305A, 305B along edges 130A, 130B of the solar panel 300. In this embodiment, the first circuit 310A and second circuit 310B are different to maximize the efficiency of the solar panel 300 in the event of a shading event casting a shadow 350A, 350B that affects the edge (edge 130B in this view) differently than the center 140.

In this embodiment, the shadows 350A, 350B move from the left edge 130B toward the center 140 in an afternoon example. As the cells 305B remain shaded for longer periods of time relative a cell or cells 305C in the center 140 of the solar panel 300 in this example, the efficiency of the cells 305B is reduced. However, the cells 305B along the edge 130B are electrically decoupled from the cells 305C in the center 140. Thus, the reduced sunlight to the cells 305B does not significantly impact the efficiency of entire solar panel 300, which results in a greater net current and/or net voltage available to the load 115 as compared to the net current and/or net voltage available to the load 115 of the solar panel 100 of Figure 1 and the solar panels 200A, 200B of Figure 2.

In this embodiment, the first circuit 310A is shown as an "H-bridge" circuit connecting the cells 305C in the center 140 of the solar panel 300. Alternatively, the first circuit 310A may be a serial-parallel circuit as well as a serial circuit as long as the first circuit 310A is different than the second circuit 310B. Likewise, the second circuit 310B is shown as a serial circuit connecting the cells 305A, 305B. Alternatively, the second circuit 310B may include a parallel, a serial-parallel and/or an "H-bridge" circuit as long as the second circuit 310B is different than the first circuit 310A. Additionally, although the edges 130A and 130B include a discrete circuit 310B, only one of the edges 130A, 130B may include the circuit 310B while the other edge of the solar panel 300 may include a circuit that is the same as the first circuit 310A.

Figure 4 depicts a top view of another embodiment of a solar panel 400 having a heterogeneous wiring scheme, which includes a first circuit 410A interconnecting cells 405E in a center 140 of the solar panel 300 and a plurality of second circuits 410B, 410C interconnecting cells 405A-405D along edges 130A-130D of the solar panel 300. In this embodiment, the first circuit 410A and second circuits 410B, 410C are different to maximize the efficiency of the solar panel 400 in the event of a shading event casting a shadow 450A, 450B that affects a corner 420 of the solar panel 400 differently than the center 140 of the solar panel 400.

In this embodiment, the shadow 450A, 450B moves from the corner 420 toward the center 140 in an afternoon example. As the cells 405B and 405C remain shaded for longer periods of time relative a cell or cells 405C-405E of the solar panel 300 in this example, the efficiency of the cells 405B, 405C are reduced. However, the cells 405C-405E are electrically decoupled from the cells 405B, 405C at the corner 420. Thus, the reduced sunlight to the cells 405B, 405C does not significantly impact the efficiency of entire solar panel 400, which results in a greater net current and/or net voltage available to the load 115 as compared to the net current and/or net voltage available to the load 115 of the solar panel 100 of Figure 1 and the solar panels 200A, 200B of Figure 2.

Although the present invention has been described in accordance with the embodiments shown, one of ordinary skill in the art will readily recognize that there could be variations to the embodiments and those variations would be within the scope of the present invention. Accordingly, many modifications may be made by one of ordinary skill in the art without departing from the scope of the appended claims.

## Claims

1. A solar panel (300, 400), comprising:
a first plurality of solar devices (340, 405E) positioned in a center (140) of the solar panel in electrical communication with a first circuit (310A, 410A); and
a second plurality of solar devices (305A, 305B, 405A-405D) surrounding the first plurality of solar devices, the second plurality of solar devices in electrical communication with a second circuit (310B, 410B, 410C), the second circuit being different than the first circuit.

2. The solar panel of claim 1, wherein the first circuit (310A, 410A) is selected from the group consisting of a serial circuit, a parallel circuit, an H-bridge circuit, and combinations thereof.

3. The solar panel of claim 1, wherein the second circuit (310B, 410B, 410C) is selected from the group consisting of a serial circuit, a parallel circuit, an H-bridge circuit, and combinations thereof.

4. The solar panel of claim 1, wherein the first circuit (310A, 410A) comprises a serial circuit and the second circuit (310B, 410B, 410C) comprises a parallel circuit.

5. The solar panel of claim 1, wherein the first circuit (310A, 410A) comprises a serial circuit and the second circuit (310B, 410B, 410C) comprises an H-bridge circuit.

6. The solar panel of claim 1, wherein the first circuit (310A, 410A) comprises a parallel circuit and the second circuit (310B, 410B, 410C) comprises an H-bridge circuit.

7. The solar panel of claim 1, wherein the first circuit (310A, 410A) comprises a parallel circuit and the second circuit (310B, 410B, 410C) comprises a series circuit.

8. The solar panel of claim 1, wherein the first circuit (310A, 410A) comprises an H-bridge circuit and the second circuit (310B, 410B, 410C) comprises a serial circuit.

9. The solar panel of claim 1, wherein the first circuit (310A, 410A) comprises an H-bridge circuit and the second circuit (310B, 410B, 410C) comprises a parallel circuit.

10. The solar panel of claim 1, wherein the solar panel (300, 400) comprises at least two edges, each of the at least two edges comprising a plurality of cells, and at least one of the at least two edges is coupled to the second circuit (310B, 410B, 410C).

11. The solar panel of claim 1, wherein the solar panel comprises at least four edges, each of the at least four edges comprising a plurality of cells, and at least two of the at least four edges is coupled to the second circuit (310B, 410B, 410C).

12. The solar panel of claim 1, wherein the solar panel comprises at least four edges, each of the at least four edges comprising a plurality of cells, and each of the four edges being coupled to the second circuit (310B, 410B, 410C).

13. A method for electrically connecting a solar panel (300, 400) comprising:
exposing light to a solar panel having a center area (140) comprising a first plurality of solar devices (340, 405E) that are at least partially bordered by a second plurality of solar devices (305A, 305B, 405A-405D) positioned outside of the center area;
electrically connecting the first plurality solar devices with a first circuit (310A, 410A); and
electrically connecting the second plurality of solar devices with a second circuit (310B, 410B, 410C) that is different than the first circuit.

14. The method of claim 13, wherein the electrical power production potential of the first plurality of solar devices (340, 405E) is independent of the electrical power production potential of the second plurality of solar devices (305A, 305B, 405A-405D).

15. The method of claim 13, wherein the first circuit (310A, 410A) is selected from the group consisting of a serial circuit, a parallel circuit, an H-bridge circuit, and combinations thereof.

16. The method of claim 13, wherein the second circuit (310B, 410B, 410C) selected from the group consisting of a serial circuit, a parallel circuit, an H-bridge circuit, and combinations thereof.

17. The method of claim 13, wherein the first circuit (310A, 410A) comprises a serial circuit and the second circuit (310B, 410B, 410C) comprises a parallel circuit.

18. The method of claim 13, wherein the first circuit (310A, 410A) comprises a serial circuit and the second circuit (310B, 410B, 410C) comprises an H-bridge circuit.

19. The solar panel of claim 13, wherein the first circuit (310A, 410A) comprises a parallel circuit and the second circuit (310B, 410B, 410C) comprises an H-bridge circuit.

20. A method for generating electrical power from a solar panel and transferring to a load, comprising:
exposing light to a solar panel having a center area (140) comprising a first plurality of solar devices (340, 405E) that are at least partially bordered by a second plurality of solar devices (305A, 305B, 405A-405D) positioned outside of the center area; and
transferring electrical power to the load from the first plurality of solar devices through an electrical circuit, the electrical power from the first plurality of solar devices being independent of the electrical power production potential of the second plurality of solar devices.

## Patentansprüche

1. Solarkollektor (300, 400), umfassend:
eine erste Mehrzahl von Solarvorrichtungen (340, 405E), die in einem Zentrum (140) des Solarkollektors in elektrischer Verbindung mit einer ersten Schaltung (310A, 410A) angeordnet ist; und
eine zweite Mehrzahl von Solarvorrichtungen (305A, 305B, 405A-405D), die die erste Mehrzahl von Solarvorrichtungen umgibt, wobei die zweite Mehrzahl von Solarvorrichtungen in elektrischer Verbindung mit einer zweiten Schaltung (310B, 410B, 410C) steht, wobei die zweite Schaltung von der ersten Schaltung verschieden ist.

2. Solarkollektor nach Anspruch 1, wobei die erste Schaltung (310A, 410A) aus der Gruppe ausgewählt ist, die aus einer Reihenschaltung, einer Parallelschaltung, einer H-Brücken-Schaltung und Kombinationen davon besteht.

3. Solarkollektor nach Anspruch 1, wobei die zweite Schaltung (310B, 410B, 410C) aus der Gruppe ausgewählt ist, die aus einer Reihenschaltung, einer Parallelschaltung, einer H-Brücken-Schaltung und Kombinationen davon besteht.

4. Solarkollektor nach Anspruch 1, wobei die erste Schaltung (310A, 410A) eine Reihenschaltung umfasst und die zweite Schaltung (310B, 410B, 410C) eine Parallelschaltung umfasst.

5. Solarkollektor nach Anspruch 1, wobei die erste Schaltung (310A, 410A) eine Reihenschaltung umfasst und die zweite Schaltung (310B, 410B, 410C) eine H-Brücken-Schaltung umfasst.

6. Solarkollektor nach Anspruch 1, wobei die erste Schaltung (310A, 410A) eine Parallelschaltung umfasst und die zweite Schaltung (310B, 410B, 410C) eine H-Brücken-Schaltung umfasst.

7. Solarkollektor nach Anspruch 1, wobei die erste Schaltung (310A, 410A) eine Parallelschaltung umfasst und die zweite Schaltung (310B, 410B, 410C) eine Reihenschaltung umfasst.

8. Solarkollektor nach Anspruch 1, wobei die erste Schaltung (310A, 410A) eine H-Brücken-Schaltung umfasst und die zweite Schaltung (310B, 410B, 410C) eine Reihenschaltung umfasst.

9. Solarkollektor nach Anspruch 1, wobei die erste Schaltung (310A, 410A) eine H-Brücken-Schaltung umfasst und die zweite Schaltung (310B, 410B, 410C) eine Parallelschaltung umfasst.

10. Solarkollektor nach Anspruch 1, wobei der Solarkollektor (300, 400) mindestens zwei Kanten umfasst, wobei jede der mindestens zwei Kanten eine Mehrzahl von Zellen umfasst und mindestens eine der mindestens zwei Kanten an die zweite Schaltung (310B, 410B, 410C) gekoppelt ist.

11. Solarkollektor nach Anspruch 1, wobei der Solarkollektor mindestens vier Kanten umfasst, wobei jede der mindestens vier Kanten eine Mehrzahl von Zellen umfasst und mindestens zwei der mindestens vier Kanten an die zweite Schaltung (310B, 410B, 410C) gekoppelt sind.

12. Solarkollektor nach Anspruch 1, wobei der Solarkollektor mindestens vier Kanten umfasst, wobei jede der mindestens vier Kanten eine Mehrzahl von Zellen umfasst und jede der vier Kanten an die zweite Schaltung (310B, 410B, 410C) gekoppelt ist.

13. Verfahren zum elektrischen Anschließen eines Solarkollektors (300, 400), umfassend:
Einwirkenlassen von Licht auf einen Solarkollektor mit einem Zentralbereich (140), der eine erste Mehrzahl von Solarvorrichtungen (340, 405E) umfasst, die zumindest teilweise an eine zweite Mehrzahl von Solarvorrichtungen (305A, 305B, 405A-405D) grenzt, die außerhalb des Zentralbereichs positioniert ist;
elektrisches Anschließen der ersten Mehrzahl von Solarvorrichtungen an eine erste Schaltung (310A, 410A); und
elektrisches Anschließen der zweiten Mehrzahl von Solarvorrichtungen an eine zweite Schaltung (310B, 410B, 410C), die von der ersten Schaltung verschieden ist.

14. Verfahren nach Anspruch 13, wobei das Produktionspotenzial von elektrischer Energie der ersten Mehrzahl von Solarvorrichtungen (340, 405E) unabhängig vom Produktionspotenzial von elektrischer Energie der zweiten Mehrzahl von Solarvorrichtungen (305A, 305B, 405A-405D) ist.

15. Verfahren nach Anspruch 13, wobei die erste Schaltung (310A, 410A) aus der Gruppe ausgewählt ist, die aus einer Reihenschaltung, einer Parallelschaltung, einer H-Brücken-Schaltung und Kombinationen davon besteht.

16. Verfahren nach Anspruch 13, wobei die zweite Schaltung (310B, 410B, 410C) aus der Gruppe ausgewählt ist, die aus einer Reihenschaltung, einer Parallelschaltung, einer H-Brücken-Schaltung und Kombinationen davon besteht.

17. Verfahren nach Anspruch 13, wobei die erste Schaltung (310A, 410A) eine Reihenschaltung umfasst und die zweite Schaltung (310B, 410B, 410C) eine Parallelschaltung umfasst.

18. Verfahren nach Anspruch 13, wobei die erste Schaltung (310A, 410A) eine Reihenschaltung umfasst und die zweite Schaltung (310B, 410B, 410C) eine H-Brücken-Schaltung umfasst.

19. Verfahren nach Anspruch 13, wobei die erste Schaltung (310A, 410A) eine Parallelschaltung umfasst und die zweite Schaltung (310B, 410B, 410C) eine H-Brücken-Schaltung umfasst.

20. Verfahren zum Erzeugen elektrischer Energie mit einem Solarkollektor und Überführen an einen Verbraucher, umfassend:
Einwirkenlassen von Licht auf einen Solarkollektor mit einem Zentralbereich (140), der eine erste Mehrzahl von Solarvorrichtungen (340, 405E) umfasst, die zumindest teilweise an eine zweite Mehrzahl von Solarvorrichtungen (305A, 305B, 405A-405D) grenzt, die außerhalb des Zentralbereichs positioniert ist; und
Überführen von elektrischer Energie an den Verbraucher von der ersten Mehrzahl von Solarvorrichtungen durch eine elektrische Schaltung, wobei die elektrische Energie von der ersten Mehrzahl von Solarvorrichtungen unabhängig vom Produktionspotenzial von elektrischer Energie der zweiten Mehrzahl von Solarvorrichtungen ist.

## Revendications

1. Panneau solaire (300, 400) comprenant :
une première pluralité de dispositifs solaires (340, 405E) positionnés dans un centre (140) du panneau solaire en communication électrique avec un premier circuit (310A, 410A) ; et
une seconde pluralité de dispositifs solaires (305A, 305B, 405A-405D) entourant la première pluralité de dispositifs solaires, la seconde pluralité de dispositifs solaires étant en communication électrique avec un second circuit (310B, 410B, 410C), le second circuit étant différent du premier circuit.

2. Panneau solaire selon la revendication 1, dans lequel le premier circuit (310A, 410A) est sélectionné dans le groupe se composant d'un circuit en série, d'un circuit parallèle, d'un circuit en pont H et de combinaisons de ceux-ci.

3. Panneau solaire selon la revendication 1, dans lequel le second circuit (310B, 410B, 410C) est sélectionné dans le groupe se composant d'un circuit en série, d'un circuit parallèle, d'un circuit en pont H et de combinaisons de ceux-ci.

4. Panneau solaire selon la revendication 1, dans lequel le premier circuit (310A, 410A) comprend un circuit en série et le second circuit (310B, 410B, 410C) comprend un circuit parallèle.

5. Panneau solaire selon la revendication 1, dans lequel le premier circuit (310A, 410A) comprend un circuit en série et le second circuit (310B, 410B, 410C) comprend un circuit en pont H.

6. Panneau solaire selon la revendication 1, dans lequel le premier circuit (310A, 410A) comprend un circuit parallèle et le second circuit (310B, 410B, 410C) comprend un circuit en pont H.

7. Panneau solaire selon la revendication 1, dans lequel le premier circuit (310A, 410A) comprend un circuit parallèle et le second circuit (310B, 410B, 410C) comprend un circuit en série.

8. Panneau solaire selon la revendication 1, dans lequel le premier circuit (310A, 410A) comprend un circuit en pont H et le second circuit (310B, 410B, 410C) comprend un circuit en série.

9. Panneau solaire selon la revendication 1, dans lequel le premier circuit (310A, 410A) comprend un circuit en pont H et le second circuit (310B, 410B, 410C) comprend un circuit parallèle.

10. Panneau solaire selon la revendication 1, dans lequel le panneau solaire (300, 400) comprend au moins deux arêtes, chacune des au moins deux arêtes comprenant une pluralité de cellules, et au moins l'une des au moins deux arêtes est couplée au second circuit (310B, 410B, 410C).

11. Panneau solaire selon la revendication 1, dans lequel le panneau solaire comprend au moins quatre arêtes, chacune des au moins quatre arêtes comprenant une pluralité de cellules, et au moins deux des au moins quatre arêtes sont couplées au second circuit (310B, 410B, 410C).

12. Panneau solaire selon la revendication 1, dans lequel le panneau solaire comprend au moins quatre arêtes, chacune des au moins quatre arêtes comprenant une pluralité de cellules, et chacune des quatre arêtes étant couplée au second circuit (310B, 410B, 410C).

13. Procédé de connexion électrique d'un panneau solaire (300, 400) comprenant :
l'exposition à la lumière d'un panneau solaire ayant une zone centrale (140) comprenant une première pluralité de dispositifs solaires (340, 405E) qui sont au moins en partie bordés par une seconde pluralité de dispositifs solaires (305A, 305B, 405A-405D) positionnés en dehors de la zone centrale ;
la connexion électrique de la première pluralité de dispositifs solaires avec un premier circuit (310A, 410A) ; et
la connexion électrique de la seconde pluralité de dispositifs solaires avec un second circuit (310B, 410B, 410C) qui est différent du premier circuit.

14. Procédé selon la revendication 13, dans lequel le potentiel de production d'énergie électrique de la première pluralité de dispositifs solaires (340, 405E) est indépendant du potentiel de production d'énergie électrique de la seconde pluralité de dispositifs solaires (305A, 305B, 405A-405D).

15. Procédé selon la revendication 13, dans lequel le premier circuit (310A, 410A) est sélectionné dans le groupe se composant d'un circuit en série, d'un circuit parallèle, d'un circuit en pont H et de combinaisons de ceux-ci.

16. Procédé selon la revendication 13, dans lequel le second circuit (310B, 410B, 410C) est sélectionné dans le groupe se composant d'un circuit en série, d'un circuit parallèle, d'un circuit en pont H et de combinaisons de ceux-ci ;

17. Procédé selon la revendication 13, dans lequel le premier circuit (310A, 410A) comprend un circuit en série et le second circuit (310B, 410B, 410C) comprend un circuit parallèle.

18. Procédé selon la revendication 13, dans lequel le premier circuit (310A, 410A) comprend un circuit en série et le second circuit (310B, 410B, 410C) comprend un circuit en pont H.

19. Panneau solaire selon la revendication 13, dans lequel le premier circuit (310A, 410A) comprend un circuit parallèle et le second circuit (310B, 410B, 410C) comprend un circuit en pont H.

20. Procédé de génération d'énergie électrique à partir d'un panneau solaire et de transfert à une charge, comprenant :
l'exposition à la lumière d'un panneau solaire ayant une zone centrale (140) comprenant une première pluralité de dispositifs solaires (340, 405E) qui sont au moins en partie bordés par une seconde pluralité de dispositifs solaires (305A, 305B, 405A-405D) positionnés en dehors de la zone centrale ; et
le transfert de l'énergie électrique à la charge à partir de la première pluralité de dispositifs solaires par un circuit électrique, l'énergie électrique de la première pluralité de dispositifs solaires étant indépendante du potentiel de production d'énergie électrique de la seconde pluralité de dispositifs solaires.
